# EUROPEAN PATENT SPECIFICATION

(11) **EP 2 635 100 B1**
(45) Date of publication and mention of the grant of the patent: **19.04.2017**
(21) Application number: 13157017.8
(22) Date of filing: 27.02.2013
(51) Int. Cl.: H05K 7/14, H05K 5/02, H05K 1/14

(54) **Mounting system for electronic modules**
Montagesystem für elektronische Module
Système de fixation pour modules électroniques

(30) Priority: 29.02.2012 BE 201200127
(43) Date of publication of application: 04.09.2013
(73) Proprietor: Fifthplay NV, 9100 Sint-Niklaas (BE)
(72) Inventor: De Witte, Wim Albert Marie-Louise, 9100 Sint-Niklaas (BE); Bodequin, Peter Robert Gabriel, 9255 Buggenhout (BE)
(74) Representative: D'Halleweyn, Nele Veerle Trees Gertrudis

(56) References cited:
- EP-A2- 0 688 067
- DE-A1-102007 004 865
- US-A1- 2008 291 713
- US-B1- 6 176 724
- US-B1- 6 650 549
- US-S1- D 562 817

## Description

The present invention relates to a mounting system according to the preamble of claim 1. The invention further relates to an assembly comprising a carrier on which such a mounting system is mounted, a gateway device in which such an assembly is received and a DIN rail module in which such an assembly is received.

In existing electronic devices such as computers electronic components and connectors are generally arranged fixedly mounted on a PCB. Such mounting systems are not very flexible and not well suited for mounting by an installer in accordance with the wishes and needs of the client.

US 6,176,724 B1 discloses an adaptor for connecting a miniaturized electronic storage module to a PC. The adaptor comprises an outer housing in which a PCB is accommodated. Electronic components are mounted on the PCB. A mini card can be received in a frame with a locking/release device.

US 2008/0291713 A1 discloses a memory card system. The memory card system comprises a plurality of modules for holding memory cards. Each module comprises supports with rails to guide the memory card in place and a latch system for securing the memory card to the module. The latches can be placed in an open and in a closed position and are provided with a knob for controlling the latches.

The object of the invention is to provide a mounting system with which electronic modules, particularly connector modules, can be mounted quickly and easily on a carrier, particularly for use in a gateway device or DIN rail module.

A mounting system according to the invention in distinguished by the features of the characterizing portion of claim 1. The system comprises at least one electronic module, a first elongate profile and a second elongate profile. The electronic module has a plate-like base and electrical contacts which are preferably arranged on an underside of the base. The base has a first side and an opposite, second side. The first elongate profile is provided with an elongate receiving channel for receiving therein the first side of the base of the one or more electronic modules. The second elongate profile is provided with a number of clamping tongues configured to hold the second side of the base. The first and second profiles can thus be arranged on the carrier such that the one or more electronic modules can be mounted between the first and the second profile with their first side received in the receiving channel, their second side held fast by the clamping tongues and their underside facing toward the carrier.

The first and the second profile have a length adapted for the purpose of receiving a plurality of electronic modules adjacently of each other between the first and the second profile.

By using such profiles and electronic modules with a base a modular system is obtained with which electronic modules can be mounted very quickly and easily on a carrier. The profiles can thus be prearranged on the carrier and the installer can provide, add on, remove etc. the necessary modules to the specifications of the client.

Positioning elements such as positioning pins, which are intended to co-act with recesses in the carrier, are preferably provided on the underside of the base. The contacts can in this way be positioned very precisely relative to contact paths on the carrier. The contacts are preferably spring contacts. The positioning pins preferably consist of at least two pins per set of spring contacts. These can for instance be two rows of spring contacts.

According to an advantageous embodiment, the clamping tongue is an upright resilient element with a protruding part configured to engage over the base. In combination with the receiving channel, such a clamping tongue ensures a firm holding of the base and a good positioning of the electrical contacts.

According to a possible embodiment, the first and the second profile form an integral part of a mounting frame. It is however also possible to provide the first and the second profile as separate components.

According to an advantageous embodiment, the receiving channel of the first profile is formed by an upper wall, a rear wall and a number of supports extending under the upper wall, wherein the first side of the base is intended to support on a support and the upper wall extends over the base. A number of recesses can be provided in the upper wall in order to facilitate arranging of the base in the receiving channel by the installer.

According to an advantageous embodiment, a number of positioning elements are provided in the receiving channel which are intended to extend between adjacent electronic modules such that the positioning in the longitudinal direction of the profiles becomes easier.

According to an advantageous embodiment, a connector element configured to make an optionally wireless connection is attached to the base of the or each electronic module. The connector element can for instance be configured to receive a plug of a cable, such as a USB plug or an Ethernet plug. The connector element can also be configured to realize a wireless connection such as a Bluetooth or WiFi connection.

According to an advantageous embodiment, the mounting system comprises a third elongate profile provided with a receiving channel for receiving therein the first side of the base; and the second profile is provided with a number of additional clamping tongues arranged such that the second profile is configured to co-act along two longitudinal sides with a second side of a base of an electronic module. Two rows of modules can be arranged in this manner.

The invention further relates to an assembly with a carrier and an embodiment of a mounting system as described above. The second profile is arranged parallel here to the first one on the carrier, and the distance between the first profile and the second profile is adapted to the distance between the first and second sides of the base. The carrier is configured for electrical coupling to the electrical contacts on the underside of the base when the base is accommodated between the first and the second profile. If a third profile is provided, it is then mounted parallel to the second profile, wherein the first profile lies on one side of the second profile and the third profile on the other side.

According to an advantageous embodiment, the carrier is provided with contact paths for the electrical contacts and/or holes for positioning pins protruding outward on the underside of the base.

According to an advantageous embodiment, the first and the second profile are attached to the carrier by means of glueing.

The carrier is preferably a printed circuit board (PCB), and still more preferably a multi-layer printed circuit board. Among other parts, a microcontroller can be arranged on the carrier. A compact whole is obtained here when the mounting system is arranged on the one side of the printed circuit board and the microcontroller is arranged on the other side of the carrier.

The invention also relates to a gateway comprising an embodiment of an assembly as described above. The invention further relates to a module configured to be mountable on a DIN rail, comprising an embodiment of an assembly as described above.

Finally, the invention relates to the use of an electronic module according to claim 23, and the use of a first profile and a second profile according to claim 24.

The present invention will be further elucidated on the basis of a number of by no means limitative exemplary embodiments of a mounting system, assembly, gateway and DIN rail module according to the invention, with reference to the accompanying figures. In the drawing:
figures 1A and 1B are schematic perspective views of an embodiment of an assembly according to the invention as seen from respectively the upper side and from the underside;
figure 1C is a schematic perspective view of an embodiment of an electronic module according to the invention;
figure 2 is a schematic top view of the embodiment of figures 1A and 1B;
figure 3 is a perspective view of an embodiment of a gateway device according to the invention in which some components arranged in the housing are shown in broken lines; and
figure 4 is a perspective view of an embodiment of a DIN rail module according to the invention.

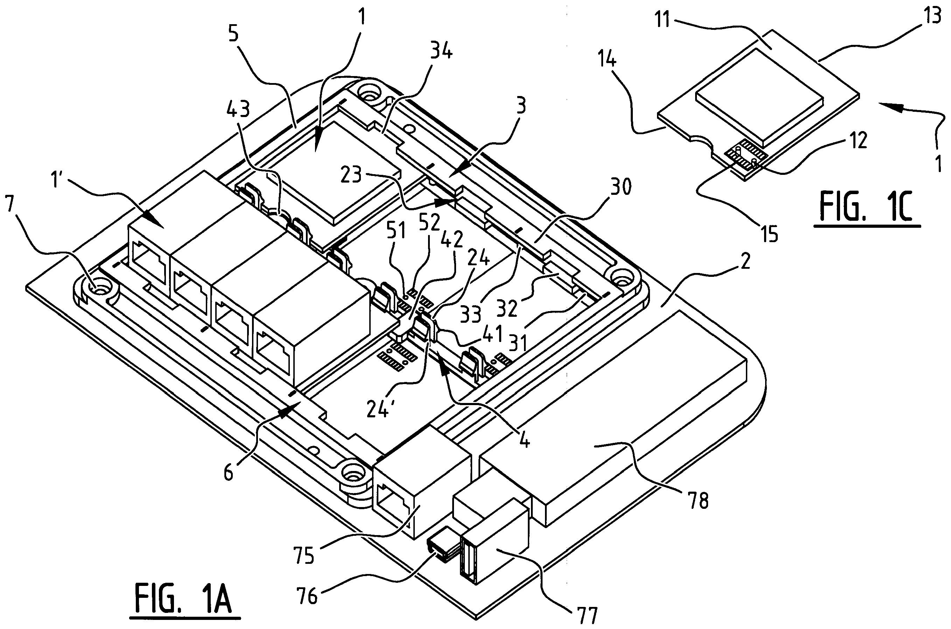

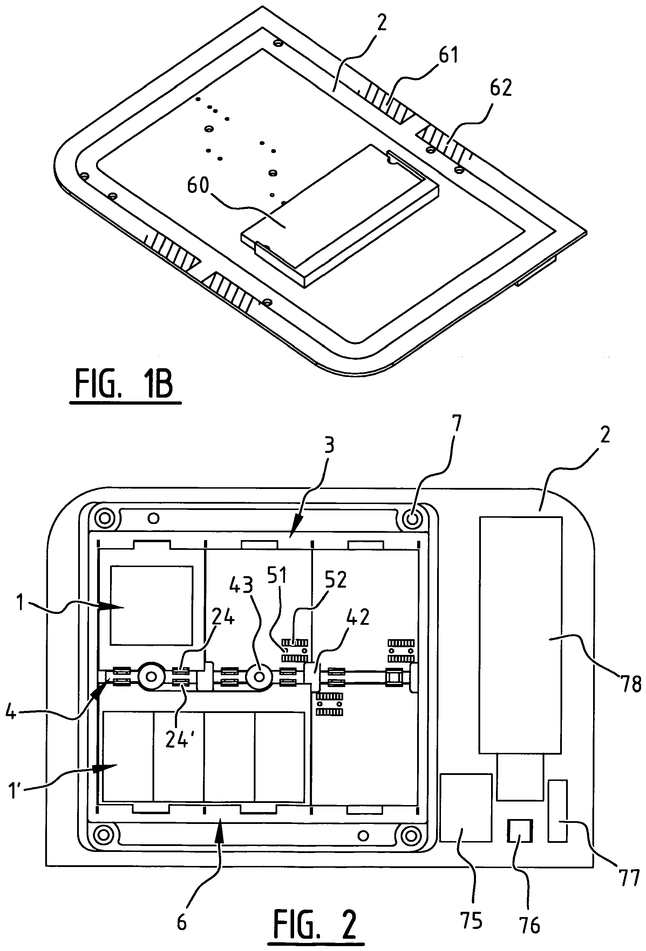

Figures 1A and 1B illustrate an embodiment of an assembly according to the invention which comprises a printed circuit board and an embodiment of a mounting system according to the invention. The mounting system is configured to mount electronic modules 1, 1' on the printed circuit board. As can be seen in figure 2, module 1' is a double module with a 4-port switch. Each electronic module 1, 1' has a plate-like base 11. Two rows of spring contacts 15 are provided on the underside of base 11 and positioning pins 12 protrude outward, see also figure 1C. Base 11 has a first side 13 and an opposite second side 14.

The mounting system comprises here a mounting frame 5 with a first elongate profile 3, a second elongate profile 4 and a third elongate profile 6. The first and third profiles 3, 6 are similarly shaped and each provided with an elongate receiving channel 23 for receiving therein the first side 13 of the base of an electronic module. The second elongate profile 4 lies between the first and the third profile and is provided with a number of clamping tongues 24, 24' configured to hold the second side 14 of a base 11. The distance between first profile 3 and second profile 4 and between second profile 4 and third profile 6 is adapted to the distance between the first and second sides 13, 14 of base 11 such that a base 11 can be held fast between the first and the second profile 3, 4 or between the second and the third profile 4, 6, see below.

In the shown variant three profiles 3, 4, 6 are provided, although the skilled person will appreciate that it is also possible to use two profiles or more than three profiles. In the shown embodiment the second profile 4 is further provided with a double row of clamping tongues, wherein the first row 24 is intended for co-action with electronic modules 1 placed between the first and the third profile 3, 4, and the second row 24' is intended for co-action with electronic module 1' between the second and the third profile. It is however also possible to provide the second profile with a single row of clamping tongues 24 and to provide a receiving channel on the longitudinal side of second profile 24 which faces toward third profile 6. Third profile 6 can then have a row of clamping tongues instead of a receiving channel.

In the illustrated variant each clamping tongue 24, 24' is formed integrally with the profile as an upright resilient element with a protruding part 41 configured to engage over base 11.

In the illustrated variant the receiving channel 23 of the first profile is formed by an upper wall 30, a rear wall 31 and a number of supports 32 extending at a pitch distance from each other under upper wall 30. The first side 13 of the base can be arranged in receiving channel 23, wherein the base supports on a support 32 and upper wall 30 extends over the base. Second profile 4 is also provided with supports 42 extending at a pitch distance from each other and intended to support the base 11 on second side 14. In the mounted position the base will in this way extend at a distance (typically several mm) from printed circuit board 2. Upper wall 30 can further be provided with a number of recesses 34 in order to facilitate arrangement between upper wall 30 and supports 32. A number of positioning elements 33, which are intended to extend between adjacent electrical modules and to facilitate the positioning in longitudinal direction of the profiles, can also be provided in receiving channel 23.

In the illustrated variant the first, the second and the third profile 3, 4, 6 have a length which is adapted to receive three electronic modules adjacently of each other between the first and the second profile 3, 4 and a further three electronic modules between the second and the third profile 4, 6. The skilled person will appreciate that this is a modular concept and that the number of profiles and the length thereof can be adapted in accordance with the desired application and of the number of modules required.

Electronic modules 1, 1' all have a base 11 on which an electronic component is provided. In the illustrated variant a first type of module 1' can be distinguished on which is mounted a connector element 15 which is configured to receive a plug of a cable, such as a USB plug or an Ethernet plug. A second type of module 1 has a base 11 on which is mounted a connector element 16 configured to bring about a wireless connection such as a Bluetooth or WiFi connection. The skilled person will appreciate that other types of electronic module with base also fall within the scope of the invention.

Printed circuit board 2 is configured for coupling to spring contacts 15, wherein positioning pins 12 protruding outward on the underside of the base provide for a very precise positioning of spring contacts 15. Printed circuit board 2 is provided for this purpose with holes 51 for positioning pins 12 and contact paths 52 against which the spring contacts 15 engage resiliently.

In the shown embodiment mounting frame 5 is configured to be attached to the printed circuit board using screws, see holes 7, 43. For many applications it is however recommended to attach the mounting frame on printed circuit point 2 by glueing such that the holes can be omitted. Printed circuit board 2 can be a multi-layer printed circuit board.

As can be seen in figure 1B, a microcontroller 60 is arranged on the underside of printed circuit board 2.

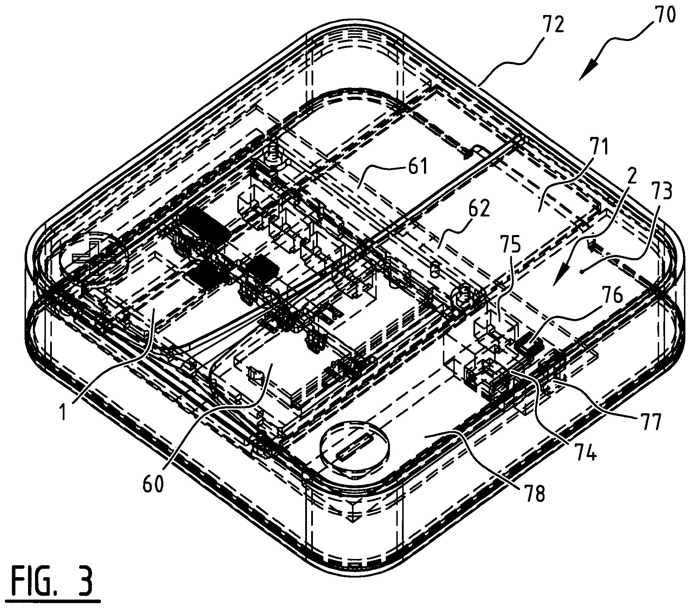

Figure 3 illustrates an embodiment of a gateway device according to the invention. Such a gateway device is typically intended for placing at an end user and for connection to a number of electronic devices such as sensors, actuators and other electronic devices such as computers, mobile phones, smart phones, tablets and so on. The gateway device is typically connected via a modem or router to the internet. Example of sensors and actuators which can be coupled to the gateway device are 3G, WiFi and Bluetooth devices, cameras, scanners, blood pressure measuring devices, devices for measuring energy consumption and so on. The gateway device is a non-service-specific device configured to provide a universal connectivity. In the illustrated embodiment the modem or router for connection to the network is not integrated in the gateway device. It is however also possible to provide modem, router or set-top box functionalities in the gateway device.

Gateway device 70 comprises a housing 72 in which the different components of the gateway device are accommodated. Housing 72 comprises, among other parts, a printed circuit board 2 on which an embodiment of a mounting system according to the invention is mounted. Housing 72 is provided with an opening 71 for cables and optionally with a slot-like recess 74 behind which a loudspeaker can be provided. The bottom of housing 72 is preferably releasable such that an installer has easy access to electronic modules 1, 1' and the cables (not illustrated). The printed circuit board of figure 1A is preferably mounted upside down in housing 72 such that the electronic modules are easily accessible once the bottom of the housing has been removed. Provided for the electronic modules with plugs is a cable (not illustrated) which is carried outside from electronic module 1' via space 73 and a recess 71 in the housing. The electronic modules are provided with spring contacts 15 which are connected via contact paths 52 to components on PCB 2, such as microcontroller 60. Storage means (not illustrated), protection circuits such as ESD protection circuits (not illustrated) and other optionally integrated circuits can further be provided. In addition, a number of fixed sockets or connectors, such as an ethernet socket 75, a socket 76 for a power supply cable, and a USB socket 77, are typically provided on PCB 2. A USB stick 78 can also be provided.

According to a possible variant, motion sensors 61, 62 can be provided. This is described in more detail in the Belgian patent application in the name of applicant, which was filed on the same day as the present patent application and the text of which is included herein by way of reference. The first motion sensor 61 extends in a U-shape along the periphery of the side of PCB 2 facing upward in housing 72, below a first zone of the housing. The second motion sensor 62 likewise extends in a U-shape along the periphery of this side of PCB 2, but on the opposite side thereof, below a second zone of the housing. The skilled person will appreciate that these zones can also be defined in different ways and that the motion sensors can also be provided at another location. The skilled person will also appreciate that the different circuits, the microcontroller and the electronic modules can be arranged at other locations on the underside or upper side of the PCB.

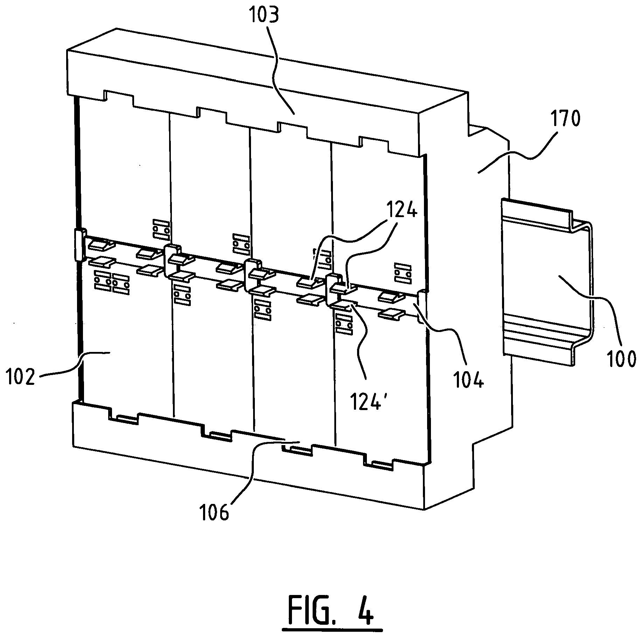

Finally, figure 4 illustrates an embodiment of a module configured to be mountable on a DIN rail 100 in which an embodiment of a mounting system according to the invention is used. The mounting system comprises three profiles 103, 104, 106 which are similar to the above described profiles 3, 4 and 6 and will consequently not be further elucidated. These profiles are attached, for instance glued, to a carrier such as a printed circuit board 102 which is mounted in or on a housing 170 of the module. This housing 170 is configured to be attachable to a DIN rail 100. A microcontroller (not shown) which is connected to the electronic modules arranged in the mounting system can be mounted on the rear side of printed circuit board 2, i.e. in housing 170.

The skilled person will appreciate that the present invention is not limited to the above described exemplary embodiments, and that many variants and additions can be envisaged within the scope of the invention, which is defined solely by the following claims.

## Claims

1. Mounting system for mounting at least one electronic component on a carrier (2), **characterized in that** the mounting system comprises:
- at least one electronic module (1, 1') with a plate-like base (11), and with contacts (15) which are arranged on an underside of the base, which base has a first side (13) and an opposite second side (14), said base being provided with an electronic component of said at least one electronic component;
- a first elongate profile (3) provided with an elongate receiving channel (23) for receiving therein the first side (13) of the base of the or each electronic module; and
- a second elongate profile (4) provided with a number of clamping tongues (24) configured to hold the second side (14) of the base of the or each electronic module;
which first and second profiles can be arranged on the carrier such that the or each electronic module can be mounted between the first and the second profile with the first side received in the receiving channel, the second side held fast by the clamping tongues and the underside facing toward the carrier; wherein the first and the second profile (3, 4) have a length adapted for the purpose of receiving a plurality of electronic modules adjacently of each other between the first and the second profile.

2. Mounting system as claimed in claim 1, **characterized in that** positioning elements, preferably positioning pins, which are intended to co-act with recesses in the carrier, protrude outward on the underside of the base.

3. Mounting system as claimed in claim 1 or 2, **characterized in that** the or each clamping tongue (24) is an upright resilient element with a protruding part (41) configured to engage over the base.

4. Mounting system as claimed in any of the foregoing claims, **characterized in that** the first and the second profile form part of a mounting frame (5).

5. Mounting system as claimed in any of the foregoing claims, **characterized in that** the receiving channel (23) of the first profile is formed by an upper wall (30), a rear wall (31) and a number of supports (32) extending under the upper wall, wherein the first side of the base is intended to support on a support (32) and the upper wall (30) extends over the base.

6. Mounting system as claimed in claim 5, **characterized in that** a number of recesses (34) are provided in the upper wall (30).

7. Mounting system as claimed in any of the foregoing claims, **characterized in that** a number of positioning elements (33) are provided in the receiving channel (23) which are intended to extend between adjacent electronic modules.

8. Mounting system as claimed in any of the foregoing claims, **characterized in that** a connector element (15, 16) configured to make an optionally wireless connection is provided on the base of the or each electronic module.

9. Mounting system as claimed in claim 8, **characterized in that** the connector element (15) is configured to receive a plug of a cable, such as a USB plug or an Ethernet plug.

10. Mounting system as claimed in claim 8, **characterized in that** the connector element (16) is configured to realize a wireless connection such as a Bluetooth or WiFi connection.

11. Mounting system as claimed in any of the foregoing claims, **characterized in that** the mounting system comprises a third elongate profile provided with a receiving channel (26) for receiving therein the first side (13) of the base; and that the second profile (4) is provided with a number of additional clamping tongues (24') arranged such that the second profile is configured to co-act along two longitudinal sides with a second side (14) of a base of an electronic module.

12. Assembly comprising a carrier and a mounting system as claimed in any of the foregoing claims, **characterized in that** the second profile is arranged parallel to the first one on the carrier, and the distance between the first profile and the second profile is adapted to the distance between the first and second sides of the base; wherein the carrier (2) is configured for coupling to the contacts (15) on the underside of the base when the base is accommodated between the first and the second profile.

13. Assembly as claimed in claim 12, **characterized in that** a third profile is mounted parallel to the second profile, wherein the first profile lies on one side of the second profile and the third profile on the other side.

14. Assembly as claimed in claim 12 or 13, comprising a mounting system according to claim 2, **characterized in that** the carrier is provided with holes in which the positioning elements can be received in the mounted position of an electronic module.

15. Assembly as claimed in any of the claims 12-14, **characterized in that** the carrier is provided with contact paths (52) for the contacts (15).

16. Assembly as claimed in any of the claims 12-15, **characterized in that** the first and the second profile are attached to the carrier by means of glueing.

17. Assembly as claimed in any of the claims 12-16, **characterized in that** the first and the second profile are attached to the carrier by means of screws.

18. Assembly as claimed in any of the claims 12-17, **characterized in that** the carrier is a printed circuit board (PCB), preferably a multi-layer printed circuit board.

19. Assembly as claimed in any of the claims 12-18, **characterized in that** a microcontroller electrically connected to the at least one electronic module is arranged on the carrier.

20. Assembly as claimed in claim 19, **characterized in that** the mounting system is arranged on the upper side of the printed circuit board and that the microcontroller is arranged on the rear side of the carrier.

21. Gateway comprising an assembly as claimed in any of the claims 12-20.

22. Module configured to be mountable on a DIN rail, comprising an assembly as claimed in any of the claims 12-20.

23. Use of an electronic module in a mounting system as claimed in any of the claims 1-11, which module has a plate-like base (11) and contacts (15) on an underside of the base, wherein a connector element (15, 16) configured to make a connection is provided on the base of the electronic module; wherein the connector element is configured to receive a plug of a cable; or wherein the connector element is configured to realize a wireless connection.

24. Use of a first elongate profile (3) and a second elongate profile (4) in an assembly of any one of the claim 12-20, wherein said first elongate profile (3) is provided with an elongate receiving channel (23) for receiving therein the first side (13) of the base of the at least one electronic module; and said second elongate profile (4) is provided with a number of clamping tongues (24) configured to hold the second side (14) of the base of the at least one electronic module; which first and second profiles can be arranged on the carrier such that the at least one electronic module can be mounted between the first and the second profile with the first side received in the receiving channel, the second side held fast by the clamping tongues and the underside facing toward the carrier; wherein the first and the second profile (3, 4) have a length adapted for the purpose of receiving a plurality of electronic modules adjacently of each other between the first and the second profile.

## Patentansprüche

1. Montagesystem zur Montage von zumindest einer elektronischen Komponente auf einem Träger (2), **dadurch gekennzeichnet, dass** das Montagesystem Folgendes umfasst:
- zumindest ein elektronisches Modul (1, 1') mit einer tellerförmigen Basis (11), und mit Kontakten (15), welche auf einer Unterseite der Basis angeordnet sind, wobei die Basis eine erste Seite (13) und eine gegenüberliegende zweite Seite (14) hat, wobei die besagte Basis mit einer elektronischen Komponente aus der zumindest einen der genannten elektronischen Komponenten bereitgestellt wird; und
- ein erstes verlängertes Profil (3), das mit einem verlängerten Empfangskanal (23) bereitgestellt wird, um darin die erste Seite (13) der Basis des oder jedes elektronischen Moduls zu erhalten; und
- ein zweites verlängertes Profil (4) mit einer Anzahl von Klammerzungen (24), die dazu konfiguriert sind, die zweite Seite (14) der Basis der oder jeder der elektronischen Module zu halten;
- wobei das erste oder das zweite Profil so auf dem Träger angeordnet werden können, dass das oder jedes elektronische Modul zwischen dem ersten und zweiten Profil montiert werden kann, wobei die erste Seite im Empfangskanal erhalten wird, die zweite Seite schnell durch die Klammerzungen gehalten wird, und die Unterseite sich nach unten zum Träger hin richtet;
- worin das erste und das zweite Profil (3, 4) eine Länge haben, die für den Zweck angepasst ist, eine Vielzahl von elektronischen benachbarten Modulen zwischen dem ersten und zweiten Profil zu erhalten.

2. Montagesystem nach Anspruch 1, **dadurch gekennzeichnet, dass** Positionierungselemente, die vorzugsweise Anschlag-stifte sind, dazu vorgesehen sind, mit Vertiefungen im Träger zusammenzuwirken, die nach außen hin auf der Unterseite der Basis ragen.

3. Montagesystem nach Anspruch 1 oder 2, **dadurch gekennzeichnet, dass** die oder jede Klammerzunge (24) ein aufrechtes belastbares Element mit einem herausragenden Teil (41) ist, das dazu konfiguriert ist, sich über der Basis zu einzurasten.

4. Montagesystem nach einem der vorstehenden Ansprüche, **dadurch gekennzeichnet, dass** das erste und zweite Profil Teil eines Montagerahmens (5) bilden.

5. Montagesystem nach einem der vorstehenden Ansprüche, **dadurch gekennzeichnet, dass** der Empfangskanal (23) des ersten Profils aus einer oberen Wand (30), einer hinteren Wand (31) und einer Anzahl von Stützen gebildet ist, die sich unter der oberen Wand erstrecken, wobei die erste Seite der Basis dafür vorgesehen ist, auf einer Stütze (32) zu unterstützen, und die obere Wand (30) sich über der Basis erstreckt.

6. Montagesystem nach einem der vorstehenden Ansprüche, **dadurch gekennzeichnet, dass** eine Anzahl von Vertiefungen (34) an der oberen Wand (30) bereitgestellt wird.

7. Montagesystem nach einem der vorstehenden Ansprüche, **dadurch gekennzeichnet, dass** eine Anzahl von Positionierungselementen (33) im Empfangskanal (23) bereitgestellt wird, der dafür vorgesehen ist, sich zwischen den benachbarten elektronischen Modulen zu erstrecken.

8. Montagesystem nach einem der vorstehenden Ansprüche, **dadurch gekennzeichnet, dass** ein Konnektorelement (15, 16) dazu konfiguriert ist, eine optionale Mobilfunkverbindung zu erstellen, die auf der Basis des oder jedes elektronischen Moduls bereitgestellt wird.

9. Montagesystem nach Anspruch 8, **dadurch gekennzeichnet, dass** das Konnektorelement (15) dazu konfiguriert ist, einen Kabelstecker, wie beispielsweise einen USB Stecker oder Ethernet Stecker, zu erhalten.

10. Montagesystem nach Anspruch 8, **dadurch gekennzeichnet, dass** das Konnektorelement (16) dazu konfiguriert ist, eine Mobilfunkverbindung, wie beispielsweise eine Bluetooth oder eine Wi-Fi Verbindung, herzustellen.

11. Montagesystem nach einem der vorstehenden Ansprüche, **dadurch gekennzeichnet, dass** das Montagesystem ein drittes verlängertes Profil umfasst, das mit einem Empfangskanal (26) bereitgestellt wird, um darin die erste Seite (13) der Basis zu erhalten; und wobei das zweite Profil (4) mit einer Anzahl von zusätzlichen Klammerzungen (24') bereitgestellt wird, die so angeordnet sind, dass das zweite Profil dazu konfiguriert ist, entlang zwei längslaufenden Seiten mit einer zweiten Seite (14) auf einer Basis eines elektronischen Moduls zusammenzuwirken.

12. Anordnung, die einen Träger und ein Montagesystem nach einem der vorstehenden Ansprüche umfasst, **dadurch gekennzeichnet, dass** das zweite Profil parallel zum ersten Profil auf dem Träger angeordnet ist, und die Entfernung zwischen dem ersten Profil und dem zweiten Profil an die Entfernung zwischen der ersten und der zweiten Seite der Basis angepasst ist; wobei der Träger (2) dazu konfiguriert ist, sich mit den Kontakten (15) auf der Unterseite der Basis zu verkoppeln wenn die Basis zwischen dem ersten und zweiten Profil untergebracht ist.

13. Anordnung nach Anspruch 12, **dadurch gekennzeichnet, dass** ein drittes Profil parallel zum zweiten Profil montiert ist, wobei das erste Profil auf einer Seite des zweiten Profils und das dritte Profil auf der anderen Seite liegt.

14. Anordnung nach Anspruch 12 oder 13, die ein Montagesystem nach Anspruch 2 umfasst, **dadurch gekennzeichnet, dass** der Träger mit Löchern bereitgestellt wird, in denen das Positionierungselement an der montierten Position eines elektronischen Moduls erhalten werden kann.

15. Anordnung nach Anrpüchen 12 bis 14, **dadurch gekennzeichnet, dass** der Träger mit Kontaktwegen (52) für die Kontakte (15) bereitgestellt wird.

16. Anordnung nach einem der Ansprüche 12 bis 15, **dadurch gekennzeichnet, dass** das erste und zweite Profil durch Aufkleben an den Trägern angebracht sind.

17. Anordnung nach einem der Ansprüche 12 bis 16, **dadurch gekennzeichnet, dass** das erste und das zweite Profile durch Schrauben an den Träger angebracht sind.

18. Anordnung nach einem der Ansprüche 12 bis 17, **dadurch gekennzeichnet, dass** der Träger eine Leiterplatte (printed circuit board PCB), mit vorzugsweise einer Mehrfachlage der Leiterplatte, ist.

19. Anordnung nach einem der Ansprüche 12 bis 18, **dadurch gekennzeichnet, dass** ein Mikrokontroller, der elektrisch mit dem zumindest einen elektronischen Modul verbunden ist, auf dem Träger angebracht wird.

20. Anordnung nach Anspruch 19, **dadurch gekennzeichnet, dass** das Montagesystem auf der hohen Seite der Leiterplatte angeordnet ist und dass der Mikrokontroller auf der hinteren Seite des Trägers angeordnet ist.

21. Gateway-Gerät, umfassend eine Anordnung nach einem der Ansprüche 12 bis 20.

22. Modul, das dazu konfiguriert ist, auf einer DIN-Schiene montiert zu werden, das eine Anordnung nach einem der Ansprüche 12 bis 20 umfasst.

23. Verwenden eines elektronischen Moduls in einem Montagesystem nach einem der Ansprüche 1 bis 11 , wobei das Modul eine tellerförmige Basis (11) und Kontakte (15) auf einer Unterseite der Basis hat, wobei das Konnektorelement (15, 16), das dazu konfiguriert ist, eine Verbindung herzustellen, auf einer Basis des elektronischen Moduls bereitgestellt wird; wobei ein Konnektorelement (15, 16) dazu konfiguriert ist, einen Kabelstecker zu erhalten;
oder wobei das Konnektorelement dazu konfiguriert ist, eine Mobilfunkverbindung herzustellen.

24. Verwenden eines ersten verlängerten Profils (3) und eines zweiten verlängerten Profils (4) in einer Anordnung nach einem der Ansprüche 12 bis 20, wobei das erste besagte verlängerte Profil (3) mit einem verlängerten Empfangskanal (23) bereitgestellt wird, um darin die erste Seite (13) der Basis des zumindest einen elektronischen Moduls zu erhalten; und besagtes zweites verlängertes Profil (4) wird mit einer Anzahl von Klammerzungen (24) bereitgestellt, die dazu konfiguriert sind, die zweite Seite (14) der Basis des zumindest einen elektronischen Moduls zu halten; wobei die ersten und zweiten Profile auf dem Träger so angeordnet werden können, dass das zumindest eine elektronische Modul zwischen dem ersten und zweiten Profil mit der ersten erhaltenen Seite im Empfangskanal montiert werden kann, wobei die zweite Seite schnell durch die Klammerzungen gehalten wird, und die Unterseite sich nach dem Träger richtet; wobei das erste und zweite Profil (3, 4) eine Länge haben, die zum Zweck des Erhaltens einer Vielzahl von elektronischen Modulen, die zwischen dem ersten und zweiten Profil benachbart sind, anpasst ist.

## Revendications

1. Système de montage pour monter au moins un composant électronique sur un support (2), **caractérisé en ce que** le système de montage comprend :
- au moins un module électronique (1, 1') avec une base de type plaque, et avec des contacts (15) qui sont disposés sur un dessous de la base, laquelle base a un premier côté (13) et un deuxième côté opposé (14), ladite base étant dotée d'un composant électronique dudit au moins un composant électronique;
- un premier profil allongé (3) muni d'un canal de réception allongé (23) pour recevoir à l'intérieur de celui-ci le premier côté (13) de la base du ou de chaque module électronique; et
- un deuxième profil allongé (4) muni d'un certain nombre de languettes de serrage (24) configurées pour tenir le deuxième côté (14) de la base du ou de chaque module électronique; lesquels premier et deuxième profils peuvent être disposés sur le support de sorte que le ou chaque module électronique peut être monté entre le premier et le deuxième profil avec le premier côté reçu dans le canal de réception, le deuxième côté étant tenu fermement par les languettes de serrage et le dessous étant orienté vers le support;
dans lequel le premier et le deuxième profil (3, 4) ont une longueur adaptée pour recevoir une pluralité de modules électroniques adjacents l'un de l'autre entre le premier et le deuxième profil.

2. Système de montage selon la revendication 1, **caractérisé en ce que** des éléments de positionnement, de préférence des broches de positionnement qui sont destinées à coopérer avec des puits dans le support, font saillie vers l'extérieur sur le dessous de la base.

3. Système de montage selon la revendication 1 ou 2, **caractérisé en ce que** la ou chaque languette de serrage (24) est un élément élastique vertical avec une partie en saillie configurée pour s'engager sur la base.

4. Système de montage selon l'une quelconque des revendications précédentes, **caractérisé en ce que** le premier et le deuxième profil font partie d'un cadre de montage (5).

5. Système de montage selon l'une quelconque des revendications précédentes, **caractérisé en ce que** le canal de réception (23) du premier profil est formé d'une paroi supérieure (30), d'une paroi arrière (31) et d'un certain nombre de supports (32) s'étendant sous la paroi supérieure, dans lequel le premier côté de la base est destiné a prendre appui sur un support (32) et la paroi supérieure (30) s'étend sur la base.

6. Système de montage selon la revendication 5, **caractérisé en ce qu'**un certain nombre de puits (34) sont prévues dans la paroi supérieure (30).

7. Système de montage selon l'une quelconque des revendications précédentes, **caractérisé en ce qu'**un certain nombre des éléments de positionnement (33) sont prévus dans le canal de réception (23) qui sont destinés à s'étendre entre des modules électroniques adjacents.

8. Système de montage selon l'une quelconque des revendications précédentes, **caractérisé en ce qu'**un élément de connexion (15, 16) configuré pour réaliser une connexion sans fil optionnelle est prévu sur la base du ou de chaque module électronique.

9. Système de montage selon la revendication 8, **caractérisé en ce que** l'élément de connexion (15) est configuré pour recevoir une prise d'un câble, telle qu'une prise USB ou une prise Ethernet.

10. Système de montage selon la revendication 8, **caractérisé en ce que** l'élément de connexion (16) est configuré pour réaliser une connexion sans fil telle qu'une connexion Bluetooth ou Wifi.

11. Système de montage selon l'une quelconque des revendications précédentes, **caractérisé en ce que** le système de montage comprend un troisième profil allongé muni d'un canal de réception (26) pour recevoir à l'intérieur de celui-ci le premier côté (13) de la base; et **en ce que** le deuxième profil (4) est muni d'un certain nombre de languettes de serrage supplémentaires (24') disposées de sorte que le deuxième profil est configuré pour coopérer le long de deux côtés longitudinaux avec un deuxième côté (14) d'une base d'un module électronique.

12. Ensemble comprenant un support et un système de montage selon l'une quelconque des revendications précédentes, **caractérisé en ce que** le deuxième profil est disposé parallèlement au premier sur le support, et la distance entre le premier profil et le deuxième profil est adaptée à la distance entre les premier et deuxième côtés de la base; le support (2) étant configuré pour être couplé avec les contacts (15) sur le dessous de la base lorsque la base est logée entre le premier et le deuxième profil.

13. Ensemble selon la revendication 12, **caractérisé en ce qu'**un troisième profil est monté parallèlement au deuxième profil, le premier profil reposant sur un côté du deuxième profil et du troisième profil sur l'autre côté.

14. Ensemble selon la revendication 12 ou 13, comprenant un système de montage selon la revendication 2, **caractérisé en ce que** le support est muni de trous dans lesquels les éléments de positionnement peuvent être reçus dans la position montée d'un module électronique.

15. Ensemble selon l'une quelconque des revendications 12 à 14, **caractérisé en ce que** le support est muni de trajets de contact (52) pour les contacts (15).

16. Ensemble selon l'une quelconque des revendications 12 à 15, **caractérisé en ce que** le premier et le deuxième profil sont fixés au support par collage.

17. Ensemble selon l'une quelconque des revendications 12 à 16, **caractérisé en ce que** le premier et le deuxième profil sont fixés au support par des vis.

18. Ensemble selon l'une quelconque des revendications 12 à 17, **caractérisé en ce que** le support est un circuit imprimé (PCB), de préférence un circuit imprimé multi-couches.

19. Ensemble selon l'une quelconque des revendications 12 à 18, **caractérisé en ce qu'**un microcontrôleur connecté électriquement à l'au moins un module électronique est disposé sur le support.

20. Ensemble selon la revendication 19, **caractérisé en ce que** le système de montage est disposé sur le côté supérieur du circuit imprimé et **en ce que** le microcontrôleur est disposé sur le côté arrière du support.

21. Passerelle comprenant un ensemble selon l'une quelconque des revendications 12 à 20.

22. Module configuré pour être monté sur un rail DIN, comprenant un ensemble selon l'une quelconque des revendications 12 à 20.

23. Utilisation d'un module électronique dans un système de montage selon l'une quelconque des revendications 1 à 11, lequel module a une base de type plaque (11) et des contacts (15) sur un dessous de la base, un élément de connexion (15, 16) configuré pour réaliser une connexion étant prévu sur la base du module électronique; l'élément de connexion étant configuré pour recevoir une prise d'un câble; ou l'élément de connexion étant configuré pour réaliser une connexion sans fil.

24. Utilisation d'un premier profil allongé (3) et d'un deuxième profil allongé (4) dans un ensemble selon l'une quelconque des revendications 12 à 20, ledit premier profil allongé (3) étant muni d'un canal de réception allongé (23) pour recevoir à l'intérieur de celui-ci le premier côté (13) de la base de l'au moins un module électronique; et ledit deuxième profil allongé (4) est muni d'un certain nombre de languettes de serrage (24) configurés pour tenir le deuxième côté (14) de la base de l'au moins un module électronique; lesquels premier et deuxième profils peuvent être disposés sur le support de sorte que l'au moins un module électronique peut être monté entre le premier et le deuxième profil avec le premier côté reçu dans le canal de réception, le deuxième côté étant tenu fermement par les languettes de serrage et le dessous étant orienté vers le support; le premier et le deuxième profil (3, 4) ayant une longueur adaptée aux fins de recevoir une pluralité de modules électroniques situés adjacents l'un de l'autre entre le premier et le deuxième profil.
